# EUROPÄISCHE PATENTANMELDUNG

(11) **EP 3 944 636 A1**
(43) Veröffentlichungstag der Anmeldung: **26.01.2022**
(21) Anmeldenummer: 21181443.9
(22) Anmeldetag: 24.06.2021
(51) Int. Cl.: H04R 25/00

(54) **HÖRGERÄT UND HÖRGERÄTE-MODUL**

(30) Priorität: 21.07.2020 DE 102020209123
(71) Anmelder: Sivantos Pte. Ltd., Singapore 539775 (SG)
(72) Erfinder: HUSUNG, Kunibert, 91052 Erlangen (DE)
(74) Vertreter: FDST Patentanwälte

(57) **Zusammenfassung**

Die Erfindung betrifft ein Hörgerät (20) aufweisend einen Eingangswandler (28), eine Signalverarbeitungseinrichtung (30) sowie einen Ausgangswandler (32) und aufweisend einen induktiven Empfänger (50), wobei der induktive Empfänger einen TMR-Sensor (50) aufweist.

## Beschreibung

Die Erfindung betrifft ein Hörgerät aufweisend einen Eingangswandler, eine Signalverarbeitungseinrichtung sowie einen Ausgangswandler und aufweisend einen induktiven Empfänger. Außerdem betrifft die Erfindung ein Hörgeräte-Modul.

Als Hörgeräte bezeichnet man typischerweise klassische Hörhilfen, die zur Versorgung von Schwerhörenden dienen. Im weiteren Sinne bezeichnet dieser Begriff jedoch auch Geräte, die zur Unterstützung von normal hörenden Menschen ausgebildet sind. Solche Hörgeräte werden auch als "Personal Sound Amplification Products" oder "Personal Sound Amplification Devices" (kurz: "PSAD") bezeichnet. Diese sind nicht zur Kompensation von Hörverlusten vorgesehen, sondern werden gezielt zur Unterstützung und Verbesserung des normalen menschlichen Hörvermögens in spezifischen Hörsituationen eingesetzt, z.B. zur Unterstützung von Jägern auf der Jagd oder zur Unterstützung der Tierbeobachtung, um Tierlaute und sonstige von Tieren erzeugte Geräusche besser wahrnehmen zu können, für Sportreporter, um ein verbessertes Sprechen und/oder Sprachverstehen in komplexer Geräuschkulisse zu ermöglichen, für Musiker, um die Belastung des Gehöres zu reduzieren, etc..

Unabhängig vom vorgesehenen Einsatzzweck weisen Hörgeräte typischerweise einen Eingangswandler, eine Signalverarbeitungseinrichtung, welche üblicherweise einen Verstärker umfasst, und einen Ausgangswandler als wesentliche Komponenten auf. Der Eingangswandler ist dabei in der Regel durch einen akusto-elektrischer Wandler ausgebildet, also zum Beispiel durch ein Mikrofon, und/oder durch einen elektromagnetischen Empfänger, beispielsweise eine Induktions-spule. Als Ausgangswandler wird meist ein elektro-akustischer Wandler eingesetzt, zum Beispiel ein Miniaturlautsprecher (auch als "Hörer" bezeichnet), oder ein elektromechanischer Wandler, zum Beispiel ein Knochenleitungshörer, und die Signalverarbeitungseinrichtung ist in der Regel durch eine auf einer Leiterplatine platzierte elektronische Schaltung realisiert.

Bekannt sind weiterhin Hörgeräte, bei denen mehrere Mikrofone als Eingangswandler verbaut sind und bei denen die Mikrofone in einem Hörgeräte-Modul zusammengefasst sind. Ein entsprechendes Hörgeräte-Modul wird auch als Mikrofon-Modul bezeichnet und ist beispielsweise in der EP 2 219 392 A2 beschrieben.

Außerdem sind Hörgeräte bekannt, die für einen Empfang von Audiosignalen einer sogenannten induktiven Höranlage ausgebildet sind und hierfür eine sogenannte Telefonspule (engl.: telecoil) oder kurz T-Spule als induktiven Empfänger aufweisen.

Ausgehend hiervon liegt der Erfindung die Aufgabe zugrunde, ein vorteilhaft ausgebildetes Hörgerät sowie ein vorteilhaft ausgebildetes Hörgeräte-Modul anzugeben.

Diese Aufgabe wird erfindungsgemäß gelöst durch ein Hörgerät mit den Merkmalen des Anspruchs 1 sowie durch ein Hörgeräte-Modul mit den Merkmalen des Anspruchs 13. Bevorzugte Weiterbildungen sind in den rückbezogenen Ansprüchen enthalten. Die im Hinblick auf das Hörgerät angeführten Vorteile und bevorzugten Ausgestaltungen sind sinngemäß auch auf das Hörgeräte-Modul übertragbar und umgekehrt.

Das erfindungsgemäße Hörgerät weist dabei einen Eingangswandler, eine Signalverarbeitungseinrichtung sowie einen Ausgangswandler auf. Hierbei ist der Eingangswandler typischerweise als akusto-elektrischer Wandler ausgebildet, also zum Beispiel als Mikrofon, und der Ausgangswandler ist üblicherweise als elektro-akustischer Wandler ausgebildet, also beispielsweise als Lautsprecher oder Miniaturlautsprecher. Weiterhin weist das Hörgerät einen induktiven Empfänger auf, wobei der induktive Empfänger einen sogenannten TMR-Sensor aufweist. Das erfindungsgemäße Hörgerät ist dabei typischerweise als Hörgerät der eingangs genannten Art ausgebildet und insbesondere als klassische Hörhilfe der eingangs genannten Art. Allerdings weist das erfindungsgemäße Hörgerät typischerweise keine Telefonspule der eingangs genannten Art auf. Der TMR-Sensor ersetzt daher bevorzugt die üblicherweise verbaute Telefonspule und in diesem Fall werden dann zweckdienlicherweise die ansonsten mittels der Telefonspule realisierten Funktionen im Hörgerät mithilfe des TMR-Sensors realisiert.

Bei einem TMR-Sensor handelt es sich hierbei um einen Sensor, bei welchem der sogenannte magnetische Tunnelwiderstand (engl. tunnel magnetoresistance, TMR) oder TMR-Effekt ausgenutzt wird. Ein entsprechender Sensor wird daher auch als tunnelmagnetoresistiver Sensor bezeichnet.

Außerdem ist das Hörgerät vorzugsweise als sogenanntes Hinter-dem-Ohr-Hörgerät (HdO) ausgebildet. Dabei weist das Hörgerät typischerweise ein Hörgeräte-Gehäuse auf, in dem die meisten der Komponenten, Baugruppen oder Bauteile des Hörgerätes untergebracht sind, sowie eine Otoplastik und ein Otoplastik-Verbindungselement, welches beispielsweise durch einen Schallschlauch ausgebildet ist und welches die Otoplastik mit dem Hörgeräte-Gehäuse verbindet.

Weiter weist die Signalverarbeitungseinrichtung typischerweise eine Leiterplatine, insbesondere eine zumindest teilweise flexible oder biegsame Leiterplatine, auf mit einer Anzahl elektronischer Bausteine. Mit Hilfe der elektronischen Bausteine ist dabei üblicherweise ein Verstärker realisiert. Je nach Ausführungsvariante ist die Signalverarbeitungseinrichtung außerdem für eine Verarbeitung von digitalen Signalen eingerichtet. In diesen Fällen weist die Signalverarbeitungseinrichtung zweckdienlicherweise einen Analog-Digital-Wandler und einen Digital-Analog-Wandler auf.

Unabhängig davon ist es zweckdienlich, wenn das Hörgerät, und insbesondere der induktive Empfänger, eingerichtet ist für einen Empfang von Signalen mit einer Frequenz im Bereich von etwa 100 Hz bis etwa 10000 Hz. Je nach Anwendungsfall ist das Hörgerät, und insbesondere der induktive Empfänger, zudem eingerichtet für einen Empfang von Signalen mit einer Frequenz im Bereich von etwa 0 Hz bis etwa 1 GHz

Dabei ist das Hörgerät, und insbesondere der induktive Empfänger, typischerweise eingerichtet für eine Datenübermittelung von einem externen Gerät hin zum Hörgerät mit dem induktiven Empfänger mittels magnetischer Wechselfelder. Außerdem ist der induktive Empfänger insbesondere eingerichtet für einen Empfang von Audiosignalen einer induktiven Höranlage.

Alternativ oder ergänzend hierzu ist der induktive Empfänger eingerichtet als Empfänger für Signale einer oder mehrerer Fernbedienungen. Je nach Anwendungsfall ist dabei eine entsprechende Fernbedienung zum Beispiel eingerichtet zur Bedienung des Hörgerätes, also zum Beispiel dazu, das Hörgerät derart anzusteuern, dass dieses den Betriebsmodus wechselt.

Vorzugsweise ist das Hörgerät, und insbesondere der induktive Empfänger, jedoch nicht eingerichtet, um Signale von einem anderen Hörgerät zu empfangen und zu verarbeiten. Ist ein Datenaustausch mit einem weiteren Hörgerät vorgesehen, so weist das Hörgerät hierfür bevorzugt eine separate Sende- und Empfangseinheit auf.

Bevorzugt ist weiterhin eine Ausgestaltung des Hörgerätes, bei der dieses ein Hörgeräte-Modul aufweist und bei der zudem bevorzugt der induktive Empfänger Teil des Hörgeräte-Moduls ist. Ein entsprechendes Hörgeräte-Modul wird dabei üblicherweise vorgefertigt und im Rahmen einer Endmontage des Hörgerätes verbaut. Dabei weist das Hörgeräte-Modul im Falle der meisten Ausführungsvarianten ein Modul-Gehäuse oder eine Trägereinheit für die übrigen Komponenten, Bauteile oder Baugruppen des Hörgeräte-Moduls auf. Jenes Modul-Gehäuse oder jene Trägereinheit weist dann typischerweise eine Anzahl Befestigungselemente zur mechanischen Befestigung auf sowie üblicherweise eine Anzahl elektrischer Verbindungselemente, zum Beispiel Anschlusskontakte, zur elektrischen Verbindung des Hörgeräte-Moduls mit den weiteren Komponenten, Baugruppen oder Bauteilen im Hörgerät, insbesondere zur elektrischen Verbindung des Hörgeräte-Moduls mit der Signalverarbeitungseinrichtung.

Außerdem ist es von Vorteil, wenn der Eingangswandler Teil eines Hörgeräte-Moduls ist und zwar insbesondere des zuvor genannten Hörgeräte-Moduls. Durch die Unterbringung des Eingangswandlers in einem Hörgeräte-Modul lässt sich unter anderem eine recht effektive Entkoppelung des Eingangswandlers von Einflüssen durch Körperschall erzielen, so wie dies beispielsweise in der eingangs genannten EP 2 219 392 A2 beschrieben ist, auf die in dieser Hinsicht hier ausdrücklich Bezug genommen wird.

Unabhängig davon, ob der Eingangswandler Teil eines Hörgeräte-Moduls ist oder nicht, weist dieser vorzugsweise ein sogenanntes MEMS-Mikrofon auf oder ist durch ein solches ausgebildet. Bei einem MEMS-Mikrofon handelt es sich typischerweise um ein Kondensatormikrofon in Mikrosystemtechnik

Außerdem weist das Hörgerät je nach Anwendungsfall zumindest zwei Eingangswandler, typischerweise zumindest zwei gleichartige Eingangswandler und insbesondere zumindest zwei MEMS-Mikrofone auf. Diese sind dann bevorzugt alle Teil eines Hörgeräte-Moduls und zwar insbesondere des zuvor genannten Hörgeräte-Moduls. Da eine Erweiterung auf mehr als einen Eingangswandler für den Fachmann jedoch keine größere Hürde darstellt, werden nachfolgend der Einfachheit halber stets Hörgeräteausführungen näher beschrieben, die nur einen Eingangswandler aufweisen.

Auch weist das Hörgerät je nach Anwendungsfall zumindest zwei TMR-Sensoren, typischerweise zumindest zwei gleichartige TMR-Sensoren, auf. Diese sind dann bevorzugt alle Teil eines Hörgeräte-Moduls und zwar insbesondere des zuvor genannten Hörgeräte-Moduls. Da eine Erweiterung auf mehr als einen TMR-Sensor für den Fachmann jedoch keine größere Hürde darstellt, werden nachfolgend der Einfachheit halber stets Hörgeräteausführungen näher beschrieben, die nur einen TMR-Sensor aufweisen.

Günstig ist weiterhin eine Ausgestaltung des Hörgerätes, bei der das Hörgerät und insbesondere ein zuvor genanntes Hörgeräte-Modul einen Gleichspannungswandler aufweist, beispielsweise einen Gleichspannungswandler, der als sogenannte Ladungspumpe ausgebildet ist.

Jener Gleichspannungswandler ist je nach Anwendungsfall für eine Ausgabespannung größer gleich 5 V ausgelegt und weiter bevorzugt für eine Ausgabespannung größer gleich 6 V, also beispielweise etwa 7 V.

Hierbei weist das Hörgerät typischerweise eine Batterie oder einen Akkumulator auf mit einer Batteriespannung bzw. Akkumulatorspannung, deren Wert vorzugsweise kleiner gleich 4,5 V, weiter bevorzugt kleiner gleich 4 V und insbesondere kleiner gleich 3,5 V ist.

Davon unabhängig ist der sogenannte Gleichspannungswandler bevorzugt für eine maximale Ausgabestromstärke größer gleich 10 µA, weiter bevorzugt größer gleich 30 µA und insbesondere größer gleich 50 µA ausgelegt, also zum Beispiel etwa 100 µA.

Je nach Ausführungsvariante ist der Gleichspannungswandler weiterhin dem TMR-Sensor vorgeschaltet. In diesem Fall dient dann der Gleichspannungswandler zweckdienlicherweise der Versorgung des TMR-Sensors mit elektrischer Energie im Betrieb des Hörgerätes. Die Ausgabespannung ist hierbei dann bevorzugt auf den Wert ausgelegt, der für den Betrieb des TMR-Sensors vorgesehen ist, und zwar bevorzugt unabhängig davon, ob der Gleichspannungswandler zusätzlich zur Versorgung weiterer Komponenten, Baugruppen oder Bauteile vorgesehen ist oder nicht.

Außerdem ist eine Ausgestaltung des Hörgerätes bevorzugt, bei der der Gleichspannungswandler dem Eingangswandler vorgeschaltet ist, insbesondere dann, wenn der Eingangswandler als ein zuvor genanntes MEMS-Mikrofon ausgestaltet ist.

Bevorzugt ist dabei insbesondere eine Ausführung des Hörgerätes, bei der dieses ein zuvor genanntes Hörgeräte-Modul aufweist und bei der der TMR-Sensor, der Eingangswandler, also insbesondere das MEMS-Mikrofon, sowie der Gleichspannungswandler Teil des Hörgeräte-Moduls sind. Bei einer derartigen Ausgestaltung ist dann weiter bevorzugt der Gleichspannungswandler dem TMR-Sensor einerseits und dem Eingangswandler, insbesondere dem MEMS-Mikrofon, andererseits vorgeschaltet. In einem solchen Fall dient dann der Gleichspannungswandler bevorzugt sowohl der Versorgung des TMR-Sensors als auch der Versorgung des Eingangswandlers mit elektrischer Energie im Betrieb des Hörgerätes.

Typisch ist weiterhin eine Ausgestaltung des Hörgerätes, bei der dieses, wie zuvor bereits angedeutet, ein Hörgeräte-Gehäuse aufweist mit einem vorderen Ende und mit einem gegenüberliegenden hinteren Ende. Dabei ist am vorderen Ende üblicherweise ein Anschluss positioniert für ein Otoplastik-Verbindungselement hin zu einer Otoplastik des Hörgerätes. Hierbei sitzt je nach Ausgestaltungsvariante der Ausgangswandler in Hörgeräte-Gehäuse, wobei in diesem Fall dann das Otoplastik-Verbindungselement typischerweise als Schallschlauch ausgebildet ist, oder der Ausgangswandler sitzt in der Otoplastik, wobei in diesem Fall dann typischerweise eine elektrische Verbindung hin zu Otoplastik ausgebildet ist. Davon unabhängig ist bevorzugt ein zuvor genanntes Hörgeräte-Modul vorgesehen und in diesem Fall ist dann das Hörgeräte-Modul weiter bevorzugt im Bereich des vorderen Endes des Hörgeräte-Gehäuses angeordnet.

Ausführungsbeispiele der Erfindung werden nachfolgend anhand einer schematischen Zeichnung näher erläutert. Darin zeigen:
- FIG 1: in einer Prinzipskizze einen Aufbau eines Hörgerätes nach dem Stand der Technik,
- FIG 2: in einer Prinzipskizze einen Aufbau eines erfindungsgemäßen Hörgerätes mit einem erfindungsgemäßen Hörgeräte-Modul sowie
- FIG 3: in einer blockschaltbildartigen Prinzipskizze das erfindungsgemäße Hörgeräte-Modul.

Einander entsprechende Teile sind in allen Figuren jeweils mit den gleichen Bezugszeichen versehen.

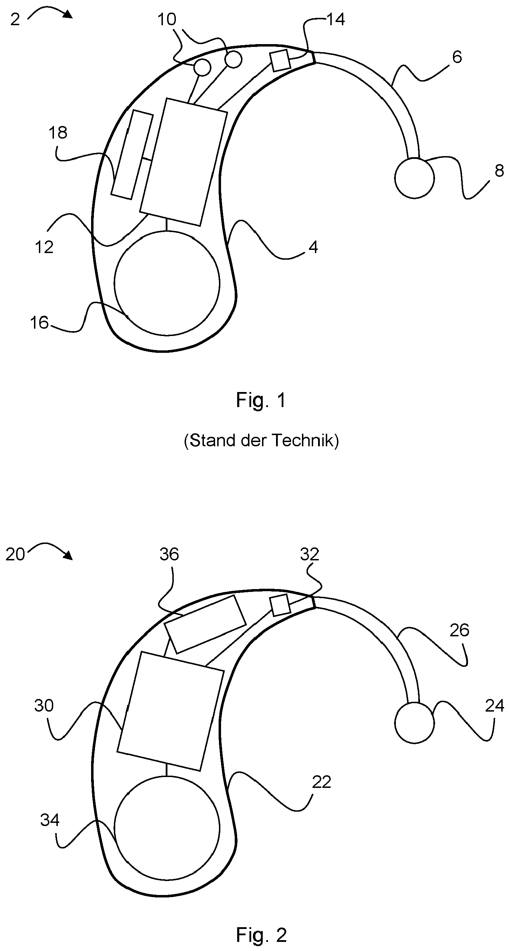

In Fig. 1 ist zunächst der prinzipielle Aufbau eines Hörgerätes 2 nach dem Stand der Technik wiedergegeben. Dieses weist ein Hörgeräte-Gehäuse 4 auf, welches über einen Schallschlauch 6 mit einer Otoplastik 8 verbunden ist. Das entsprechende Hörgerät 2 ist somit als sogenanntes Hinter-dem-Ohr-Hörgerät (HdO) ausgebildet. Im Hörgeräte-Gehäuse 4 sind als wesentliche Komponenten zwei Mikrofone 10, eine Signalverarbeitungseinrichtung 12, ein Lautsprecher 14 sowie ein Akkumulator 16 verbaut. Ergänzend weist das Hörgerät 2 noch eine sogenannte Telefonspule 18 auf als induktiven Empfänger.

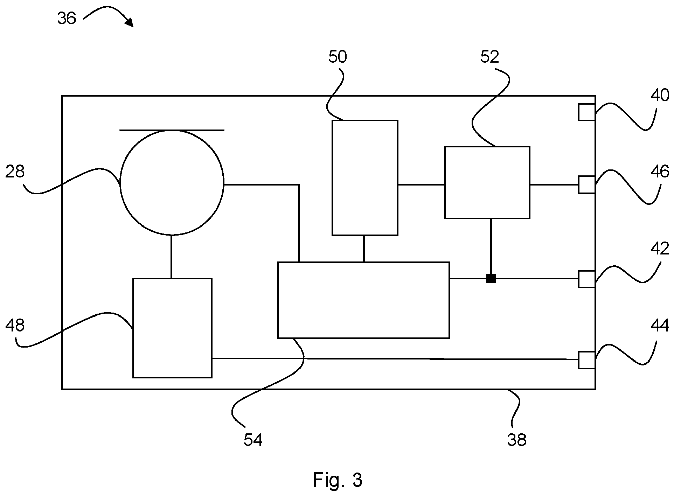

Eine Ausführungsvariante eines erfindungsgemäßen Hörgerätes 20 ist in Fig. 2 und Fig. 3 dargestellt. Auch dieses Hörgerät 20 ist, wie aus Fig. 2 hervorgeht, als sogenanntes Hinter-dem-Ohr-Hörgerät (HdO) ausgebildet und weist ein Hörgeräte-Gehäuse 22, eine Otoplastik 24 und einen Schallschlauch 26 auf, wobei der Schallschlauch 26 die Otoplastik 24 mit dem Hörgeräte-Gehäuse 22 verbindet. Außerdem weist das Hörgerät 20 als wesentliche Komponenten ein Mikrofon auf, welches als MEMS-Mikrofon 28 ausgestaltet ist, sowie eine Signalverarbeitungseinrichtung 30, einen Lautsprecher 32 und einen Akkumulator 34.

Das Mikrofon ist hierbei Teil eines Hörgeräte-Moduls 36, welches in Fig. 3 detaillierter dargestellt ist. Das Hörgeräte-Modul 36 weist im Ausführungsbeispiel ein Modul-Gehäuse 38 auf, in welchem die übrigen Komponenten des Hörgeräte-Moduls 36 angeordnet sind. Dabei wird das Hörgeräte-Modul 36 typischerweise vorgefertigt und im Rahmen einer Endmontage des Hörgerätes 20 verbaut. Hierzu weist das Modul-Gehäuse 38 üblicherweise eine Anzahl nicht näher dargestellter Befestigungselemente zur mechanischen Befestigung auf sowie eine Anzahl elektrische Verbindungselemente zur elektrischen Verbindung des Hörgeräte-Moduls 36 mit der Signalverarbeitungseinrichtung 30.

Im Ausführungsbeispiel handelt es sich bei der Anzahl elektrischer Verbindungselemente um vier Anschlusskontakte 40 bis 46. Hierbei dient ein erster Anschlusskontakt 40 zur Vorgabe eines Massepotenzials oder Referenzpotenzials für das Hörgeräte-Modul 36 im Betrieb des Hörgerätes 20 und ein zweiter Anschlusskontakt 42 zur Zuführung einer Versorgungsspannung für das Hörgeräte-Modul 36 im Betrieb des Hörgerätes 20, wobei das Massepotenzial bzw. Referenzpotenzial und die Versorgungsspannung im Ausführungsbeispiel über die Signalverarbeitungseinrichtung 30 zugeführt wird und aus dem Akkumulator 34 gespeist wird. Die weitere Zuführung des Massepotenzials oder Referenzpotenzials zu einzelnen Komponenten des Hörgeräte-Moduls 36 ist in Fig. 3 der Einfachheit halber nicht mit dargestellt.

Ein dritter Anschlusskontakt 44 dient der Weitergabe von mittels des MEMS-Mikrofons 28 generierten Mikrofonsignalen an die Signalverarbeitungseinrichtung 30 im Betrieb des Hörgerätes 20, wobei im Ausführungsbeispiel der dritte Anschlusskontakt 44 über einen Impedanzwandler 48 mit dem MEMS-Mikrofon 28 verbunden ist.

Der vierte Anschlusskontakt 46 schließlich dient der Weitergabe von Empfängersignalen an die Signalverarbeitungseinrichtung 30 im Betrieb des Hörgerätes 20. Entsprechende Empfängersignale werden dabei Betrieb des Hörgerätes 20 generiert mithilfe eines induktiven Empfängers, welcher Teil des Hörgerätes-Moduls 36 ist und welcher als TMR-Sensor 50 ausgebildet ist. Dabei ist im Ausführungsbeispiel zwischen dem TMR-Sensor 50 und dem vierten Anschlusskontakt 46 ein Vorverstärker 52 positioniert, der ebenfalls Teil des Hörgerät-Moduls 36 ist. Im Ausführungsbeispiel dient der induktive Empfänger dem Empfang von Audiosignalen einer induktiven Höranlage.

Weiterhin weist das Hörgeräte-Modul 36 im Ausführungsbeispiel einen Gleichspannungswandler 54 auf, der insbesondere als sogenannte Ladungspumpe ausgebildet ist. Dieser Gleichspannungswandler 54 ist im Ausführungsbeispiel sowohl dem Mikrofon 28 als auch dem induktiven Empfänger vorgeschaltet und versorgt somit sowohl den induktiven Empfänger als auch das Mikrofon 28 im Betrieb des Hörgerätes 20 mit elektrischer Leistung.

Bevorzugt weist ein erfindungsgemäßes Hörgeräte-Modul 36 keine weiteren und/oder keine sonstigen elektrischen und/oder elektronischen Baugruppen und/oder Bausteine auf. Ein erfindungsgemäßes Hörgeräte-Modul 36 weist bevorzugt keinen Analog-Digital-Wandler auf. Außerdem weist ein erfindungsgemäßes Hörgeräte-Modul 36 bevorzugt keinen Digital-Analog-Wandler. Insbesondere weist ein erfindungsgemäßes Hörgeräte-Modul 36 keine Einheit zur Verarbeitung digitaler Signale auf.

### Bezugszeichenliste

- 2: Hörgerät (SdT)
- 4: Hörgeräte-Gehäuse
- 6: Schallschlauch
- 8: Otoplastik
- 10: Mikrofon
- 12: Signalverarbeitungseinrichtung
- 14: Lautsprecher
- 16: Akkumulator
- 18: Telefonspule

- 20: Hörgerät
- 22: Hörgeräte-Gehäuse
- 24: Otoplastik
- 26: Schallschlauch
- 28: MEMS-Mikrofon
- 30: Signalverarbeitungseinrichtung
- 32: Lautsprecher
- 34: Akkumulator
- 36: Hörgeräte-Modul
- 38: Modul-Gehäuse
- 40: erster Anschlusskontakt
- 42: zweiter Anschlusskontakt
- 44: dritter Anschlusskontakt
- 46: vierter Anschlusskontakt
- 48: Impedanzwandler
- 50: TMR-Sensor
- 52: Vorverstärker
- 54: Gleichspannungswandler

## Patentansprüche

1. Hörgerät (20) aufweisend einen Eingangswandler (28), eine Signalverarbeitungseinrichtung (30) sowie einen Ausgangswandler (32) und aufweisend einen induktiven Empfänger (50),
**dadurch gekennzeichnet,**
**dass**
- der induktive Empfänger einen TMR-Sensor (50) aufweist,
- der induktive Empfänger (50) eingerichtet ist für einen Empfang von Audiosignalen einer induktiven Höranlage,
- dieses einen Gleichspannungswandler (54) aufweist,
- der Gleichspannungswandler (54) dem TMR-Sensor (50) vorgeschaltet ist und
- der Gleichspannungswandler (54) dem Eingangswandler (28) vorgeschaltet ist.

2. Hörgerät (20) nach Anspruch 1,
**dadurch gekennzeichnet,**
**dass** der induktive Empfänger (50) eingerichtet ist für einen Empfang von Signalen mit Frequenzen im Bereich 100 Hz bis 10000 Hz.

3. Hörgerät (20) nach Anspruch 1 oder 2,
**dadurch gekennzeichnet,**
**dass** der Eingangswandler (28) ein MEMS-Mikrofon (28) aufweist.

4. Hörgerät (20) nach einem der Ansprüche 1 bis 3,
**dadurch gekennzeichnet,**
**dass** der Gleichspannungswandler (54) für eine Ausgabespannung größer gleich 5 V und insbesondere größer gleich 6 V ausgelegt ist.

5. Hörgerät (20) nach einem der Ansprüche 1 bis 4,
**dadurch gekennzeichnet,**
**dass** der Gleichspannungswandler (54) für eine maximale Ausgabestromstärke größer gleich 10 µA und insbesondere größer gleich 50 µA ausgelegt ist

6. Hörgerät nach einem der Ansprüche 1 bis 5,
**dadurch gekennzeichnet,**
**dass** dieses ein Hörgeräte-Modul (36) aufweist und dass der induktive Empfänger (50) Teil des Hörgeräte-Moduls (36) ist.

7. Hörgerät (20) nach Anspruch 6,
**dadurch gekennzeichnet,**
**dass** der Eingangswandler (28) Teil des Hörgeräte-Moduls (36) ist.

8. Hörgerät (20) nach Anspruch 6 oder 7,
**dadurch gekennzeichnet,**
**dass** der Gleichspannungswandler (54) Teil des Hörgeräte-Modul (36) ist.

9. Hörgerät (20) nach einem der Ansprüche 6 bis 8,
**dadurch gekennzeichnet,**
**dass** dieses ein Hörgeräte-Gehäuse (22) aufweist mit einem vorderen Ende, an welchem ein Anschluss für ein Otoplastik-Verbindungselement (26) positioniert ist, sowie mit einem gegenüberliegenden hinteren Ende und dass das Hörgeräte-Modul (36) im Bereich des vorderen Endes im Hörgeräte-Gehäuse (22) angeordnet ist.

10. Hörgeräte-Modul (36) ausgebildet für ein Hörgerät (20) nach einem der Ansprüche 6 bis 9.
